# EUROPEAN PATENT APPLICATION

(11) **EP 3 806 326 A1**
(43) Date of publication of application: **14.04.2021**
(21) Application number: 19814331.5
(22) Date of filing: 30.05.2019
(51) Int. Cl.: H02S 40/22, G02B 3/08

(54) **FRESNEL LENS FOR CONCENTRATED PHOTOVOLTAIC POWER GENERATION DEVICE, CONCENTRATED PHOTOVOLTAIC POWER GENERATION SYSTEM, AND METHOD OF MANUFACTURING FRESNEL LENS FOR CONCENTRATED PHOTOVOLTAIC POWER GENERATION DEVICE**

(30) Priority: 04.06.2018 JP 2018107130
(71) Applicant: SUMITOMO ELECTRIC INDUSTRIES, LTD., Osaka-shi, Osaka 541-0041 (JP)
(72) Inventor: INAGAKI, Makoto, Osaka-shi, Osaka 541-0041 (JP); NAGAI, Youichi, Osaka-shi, Osaka 541-0041 (JP); IWASAKI, Takashi, Osaka-shi, Osaka 541-0041 (JP)
(74) Representative: Boult Wade Tennant LLP
(86) International application number: PCT/JP2019/021627
(87) International publication number: WO 2019/235365

(57) **Abstract**

A Fresnel lens (32f) for a concentrator photovoltaic apparatus includes: a glass substrate portion (61) having a circular first corner portion (613, 618); and a synthetic resin portion (62) overlaid on one surface of the glass substrate portion (61) and having a circular second corner portion (623, 628) having a radius equal to that of the first corner portion (613, 618) and coaxially overlapping the first corner portion (613, 618).

## Description

### TECHNICAL FIELD

The present invention relates to a Fresnel lens for a concentrator photovoltaic apparatus, a concentrator photovoltaic system, and a method for manufacturing a Fresnel lens for a concentrator photovoltaic apparatus. This application claims priority on Japanese Patent Application No. 2018-107130 filed on June 4, 2018, the entire content of which is incorporated herein by reference.

### BACKGROUND ART

In a concentrator photovoltaic apparatus, Fresnel lenses are used to converge sunlight. PATENT LITERATURE 1 discloses a Fresnel lens in which a Fresnel lens molded layer formed from a silicone resin is provided on one surface of a support substrate that is a flat glass plate. A fine pattern of the Fresnel lens is formed on the Fresnel lens molded layer. PATENT LITERATURE 2 discloses a Fresnel lens that is an optical element including: a glass substrate; and a sheet-like molded body that is formed from an acrylic resin, that has a Fresnel lens pattern on one surface thereof, and that has another surface adhered to the glass substrate.

### CITATION LIST

### [PATENT LITERATURE]

PATENT LITERATURE 1: Japanese Laid-Open Patent Publication No. 2007-271857
PATENT LITERATURE 2: International Publication No. WO2015/102093

### SUMMARY OF INVENTION

A Fresnel lens for a concentrator photovoltaic apparatus according to an aspect of the present disclosure includes: a glass substrate portion having a circular first corner portion; and a synthetic resin portion overlaid on one surface of the glass substrate portion and having a circular second corner portion having a radius equal to that of the first corner portion and coaxially overlapping the first corner portion.

A Fresnel lens for a concentrator photovoltaic apparatus according to an aspect of the present disclosure includes: a glass substrate portion having, on one surface thereof, a first Fresnel shape having a plurality of concentric circular first projection portions; and a synthetic resin portion overlaid on the one surface of the glass substrate portion and having, on one surface thereof, a second Fresnel shape having a plurality of concentric circular second projection portions having radii equal to those of the first projection portions, respectively, and coaxially overlapping the first projection portions, respectively.

A concentrator photovoltaic system according to an aspect of the present disclosure includes: a plurality of concentrator photovoltaic apparatuses; and an inverter apparatus configured to convert DC power outputted from the plurality of concentrator photovoltaic apparatuses, into AC power, and each of the concentrator photovoltaic apparatuses includes a concentrator photovoltaic panel including the above Fresnel lens for a concentrator photovoltaic apparatus.

A method for manufacturing a Fresnel lens for a concentrator photovoltaic apparatus according to an aspect of the present disclosure includes the steps of: producing a glass substrate portion including, on one surface thereof, a Fresnel shape having a plurality of concentric circular first projection portions, by pressing or cutting; fitting the glass substrate portion to a mold having a plurality of concentric circular recess portions, such that the plurality of first projection portions are accommodated in the plurality of recess portions, respectively; filling a space between the glass substrate portion and the mold with a heated and melted synthetic resin; and forming a synthetic resin portion overlaid on the one surface of the glass substrate and having a plurality of concentric circular second projection portions having radii equal to those of the first projection portions, respectively, and coaxially overlapping the first projection portions, respectively, by cooling the synthetic resin.

### BRIEF DESCRIPTION OF DRAWINGS

FIG. 1 is a perspective view showing a configuration of a concentrator photovoltaic apparatus according to an embodiment.
FIG. 2 is a perspective view showing an example of a configuration of a concentrator photovoltaic module according to the embodiment.
FIG. 3 is an example of a cross-sectional view representing a minimum basic configuration of an optical system of the concentrator photovoltaic apparatus according to the embodiment.
FIG. 4 is a side cross-sectional view showing an example of a configuration of a Fresnel lens according to the embodiment.
FIG. 5 is a partially enlarged side cross-sectional view of the Fresnel lens according to the embodiment.
FIG. 6A is a diagram for describing an example of a method for manufacturing the Fresnel lens according to the embodiment.
FIG. 6B is a diagram for describing the example of the method for manufacturing the Fresnel lens according to the embodiment.
FIG. 6C is a diagram for describing the example of the method for manufacturing the Fresnel lens according to the embodiment.
FIG. 6D is a diagram for describing the example of the method for manufacturing the Fresnel lens according to the embodiment.
FIG. 7 is a diagram showing an example of a configuration of a concentrator photovoltaic system according to the embodiment.
FIG. 8 is a side cross-sectional view showing a configuration of a Fresnel lens according to a first modification of the embodiment.
FIG. 9 is a side cross-sectional view showing a configuration of a Fresnel lens according to a second modification of the embodiment.
FIG. 10A is an enlarged front view of a center portion of a Fresnel lens according to a third modification of the embodiment.
FIG. 10B is a cross-sectional view of the Fresnel lens taken along a line A-A shown in FIG. 10A.
FIG. 11 is a partially enlarged side cross-sectional view of a Fresnel lens according to a fourth modification of the embodiment.
FIG. 12 is a partially enlarged side cross-sectional view of a Fresnel lens according to a fifth modification of the embodiment.
FIG. 13 is a partially enlarged side cross-sectional view of a Fresnel lens according to a sixth modification of the embodiment.

### DESCRIPTION OF EMBODIMENTS

### <Problems to be solved by the present disclosure>

The Fresnel lenses disclosed in PATENT LITERATURES 1 and 2 have the following problems. First, the silicone resin and the acrylic resin that have transparency are expensive, so that the material costs of the Fresnel lenses increase. In addition, the silicone resin and the acrylic resin have large displacement due to thermal expansion and humidity and easily deform, and thus a change in focal length due to temperature and humidity and deterioration of the condensing characteristics occur, causing variations in power generation amount and a reduction in total power generation amount. Moreover, the silicone resin and the acrylic resin may cause a decomposition reaction when absorbing ultraviolet rays, and the transmittance may decrease, which may also cause variations in power generation amount and a reduction in total power generation amount.

### <Effects of the present disclosure>

According to the present disclosure, the material cost of the Fresnel lens can be reduced, and variations in power generation amount and a reduction in total power generation amount can also be suppressed.

### <Outline of embodiment of the present disclosure>

Hereinafter, the outline of an embodiment of the present disclosure is listed and described.
(1) A Fresnel lens for a concentrator photovoltaic apparatus according to the present embodiment includes: a glass substrate portion having a circular first corner portion; and a synthetic resin portion overlaid on one surface of the glass substrate portion and having a circular second corner portion having a radius equal to that of the first corner portion and coaxially overlapping the first corner portion. Accordingly, the second corner portion is provided so as to cover the first corner portion, and the volume of the synthetic resin portion can be reduced. Thus, the amount of an expensive synthetic resin used can be reduced, so that the material cost of the Fresnel lens is reduced. In addition, since the volume of the synthetic resin portion is reduced, the influence of thermal deformation and deterioration of the synthetic resin is suppressed, and variations in power generation amount and a reduction in total power generation amount are suppressed. The term "corner" includes a "projected corner" and a "recessed corner".
(2) In the Fresnel lens for a concentrator photovoltaic apparatus according to the present embodiment, the first corner portion may be a first projection portion having a projected corner shape, the second corner portion may be a second projection portion having a projected corner shape, and an end of the second projection portion may be sharper than an end of the first projection portion. Glass has low moldability, and it is difficult to form a sharp projection portion from glass. With the above configuration, the sharpness of the first projection portion can be decreased, so that it is easy to mold the glass substrate portion. In addition, since the synthetic resin portion has high moldability, the sharp second projection portion can be easily molded. Therefore, a Fresnel lens having good optical characteristics can be easily molded.
(3) In the Fresnel lens for a concentrator photovoltaic apparatus according to the present embodiment, a width of the end of the first projection portion may be equal to or larger than 0.1 mm and equal to or less than 1 mm. Accordingly, the sharpness of the first projection portion can be decreased, so that it is easy to mold the glass substrate portion.
(4) In the Fresnel lens for a concentrator photovoltaic apparatus according to the present embodiment, the first corner portion may be a first recess portion having a recessed corner shape, the second corner portion may be a second recess portion having a recessed corner shape, and a bottom of the second recess portion may be sharper than a bottom of the first recess portion. Glass has low moldability, and it is difficult to form a sharp recess portion from glass. With the above configuration, the sharpness of the first recess portion can be decreased, so that it is easy to mold the glass substrate portion. In addition, since the synthetic resin portion has high moldability, the sharp second recess portion can be easily molded. Therefore, a Fresnel lens having good optical characteristics can be easily molded.
(5) In the Fresnel lens for a concentrator photovoltaic apparatus according to the present embodiment, a width of the bottom of the first recess portion may be equal to or larger than 0.1 mm and equal to or less than 1 mm. Accordingly, the sharpness of the first recess portion can be decreased, so that it is easy to mold the glass substrate portion.
(6) In the Fresnel lens for a concentrator photovoltaic apparatus according to the present embodiment, the glass substrate portion may have a first flat surface at a center portion thereof, and the synthetic resin portion may have, at a center portion thereof, a second flat surface overlapping the first flat surface. Accordingly, in aligning the Fresnel lens and a cell that is a photovoltaic element, the cell can be easily viewed or clearly imaged through the first and second flat surfaces, so that it is easy to align the cell and the Fresnel lens with each other.
(7) In the Fresnel lens for a concentrator photovoltaic apparatus according to the present embodiment, the glass substrate portion may have an outer peripheral portion having a constant thickness, and the outer peripheral portion may project further than a position of the end of the second projection portion in a projection direction in which the second projection portion projects. Accordingly, another object is inhibited from coming into contact with the second projection portion during transportation or the like, so that damage and adhesion of dirt to the Fresnel lens can be inhibited.
(8) In the Fresnel lens for a concentrator photovoltaic apparatus according to the present embodiment, the glass substrate portion may have an outer peripheral portion having a constant thickness, the outer peripheral portion may have an end surface facing in a projection direction in which the second projection portion projects, and a height in the projection direction of the end surface may be equal to or smaller than a height in the projection direction of a groove formed between the two first projection portions adjacent to each other. Accordingly, the amount of glass used is reduced, so that the cost can be reduced. In addition, when mounting the Fresnel lens to a housing of a photovoltaic panel, it is possible to align the Fresnel lens and the housing with each other by fitting the housing to a step portion formed at the boundary between the outer peripheral portion and the Fresnel lens surface.
(9) In the Fresnel lens for a concentrator photovoltaic apparatus according to the present embodiment, the synthetic resin portion may be formed from a phenyl-based silicone resin. The phenyl-based silicone resin has low resistance to heat and ultraviolet rays, but has excellent optical characteristics that it has a reflective index close to that of glass. By forming the synthetic resin portion having a low volume from the phenyl-based silicone resin, the influence of thermal deformation and deterioration of the synthetic resin can be reduced, so that a Fresnel lens having excellent optical characteristics can be formed.
(10) A Fresnel lens for a concentrator photovoltaic apparatus according to the present embodiment includes: a glass substrate portion having, on one surface thereof, a first Fresnel shape having a plurality of concentric circular first projection portions; and a synthetic resin portion overlaid on the one surface of the glass substrate portion and having, on one surface thereof, a second Fresnel shape having a plurality of concentric circular second projection portions having radii equal to those of the first projection portions, respectively, and coaxially overlapping the first projection portions, respectively. Accordingly, the second projection portion is provided so as to cover the first projection portion, and the volume of the synthetic resin portion can be reduced. Thus, the amount of an expensive synthetic resin used can be reduced, so that the material cost of the Fresnel lens is reduced. In addition, since the volume of the synthetic resin portion is reduced, the influence of thermal deformation and deterioration of the synthetic resin is suppressed, and variations in power generation amount and a reduction in total power generation amount are suppressed.
(11) A concentrator photovoltaic system according to the present embodiment includes: a plurality of concentrator photovoltaic apparatuses; and an inverter apparatus configured to convert DC power outputted from the plurality of concentrator photovoltaic apparatuses, into AC power, and each of the concentrator photovoltaic apparatuses includes a concentrator photovoltaic panel including the Fresnel lens for a concentrator photovoltaic apparatus according to any one of the above (1) to (10). Accordingly, the cost of the entire concentrator photovoltaic system can be reduced, and variations in power generation amount and a reduction in total power generation amount can be suppressed.
(12) A method for manufacturing a Fresnel lens for a concentrator photovoltaic apparatus according to the present embodiment includes the steps of: producing a glass substrate portion including, on one surface thereof, a Fresnel shape having a plurality of concentric circular first projection portions, by pressing or cutting; fitting the glass substrate portion to a mold having a plurality of concentric circular recess portions, such that the plurality of first projection portions are accommodated in the plurality of recess portions, respectively; filling a space between the glass substrate portion and the mold with a heated and melted synthetic resin; and forming a synthetic resin portion overlaid on the one surface of the glass substrate and having a plurality of concentric circular second projection portions having radii equal to those of the first projection portions, respectively, and coaxially overlapping the first projection portions, respectively, by cooling the synthetic resin. Thus, the amount of an expensive synthetic resin used can be reduced, so that the material cost of the Fresnel lens is reduced. In addition, since the volume of the synthetic resin portion is reduced, the influence of thermal deformation and deterioration of the synthetic resin is suppressed, and variations in power generation amount and a reduction in total power generation amount are suppressed.

### <Details of embodiment of the present disclosure>

Hereinafter, an embodiment of the present disclosure will be described in detail with reference to the drawings.

### [1-1. Configuration of concentrator photovoltaic apparatus]

Hereinafter, a configuration of a concentrator photovoltaic apparatus according to the present embodiment will be described.

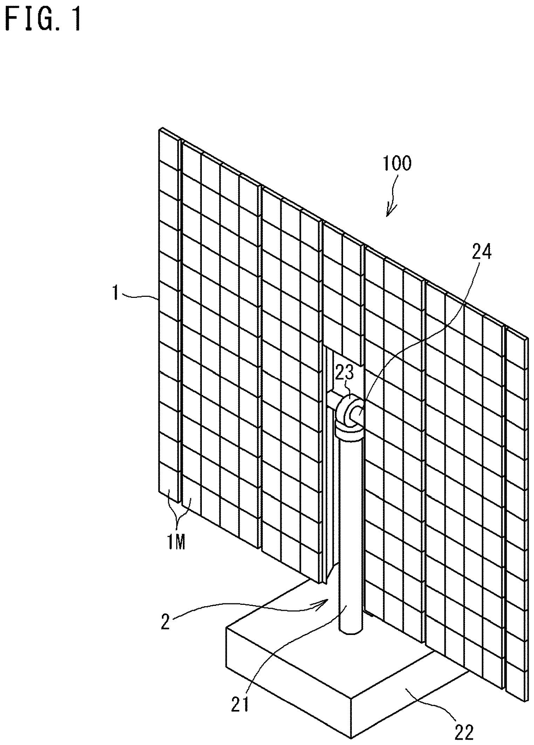

FIG. 1 is a perspective view showing the configuration of the concentrator photovoltaic apparatus according to the present embodiment. The concentrator photovoltaic apparatus 100 includes: an array 1 having a shape that is continuous on the upper side and divided into right and left portions on the lower side; and a support device 2 for supporting the array 1. The array 1 is an example of a concentrator photovoltaic panel according to the embodiment. The array 1 is formed by arraying concentrator photovoltaic modules 1M on a mounting base (not shown) on the rear surface side. In the example shown in FIG. 1, the array 1 is formed as an assembly composed of 200 modules 1M in total, i.e., 192 (96 (= 12×8)×2) modules 1M forming the right and left wings and 8 modules 1M forming a connection portion at the center.

The support device 2 includes a post 21, a base 22, a biaxial drive part 23, and a horizontal shaft 24 serving as a drive shaft. The lower end of the post 21 is fixed to the base 22, and the upper end of the post 21 is provided with the biaxial drive part 23. A box (not shown) for electric connection and for accommodating electric circuits is provided in the vicinity of the lower end of the post 21.

The base 22 is firmly embedded in the ground to an extent that only the upper surface thereof is shown. In the state where the base 22 is embedded in the ground, the post 21 extends vertically and the horizontal shaft 24 extends horizontally. The biaxial drive part 23 can rotate the horizontal shaft 24 in two directions of azimuth (angle around the post 21 as the center axis) and elevation (angle around the horizontal shaft 24 as the center axis). The horizontal shaft 24 is fixed to the mounting base. Therefore, if the horizontal shaft 24 is rotated in the direction of azimuth or elevation, the array 1 is also rotated in that direction.

FIG. 1 shows the support device 2 supporting the array 1 by means of the single post 21. However, the configuration of the support device 2 is not limited thereto. That is, any support device that can support the array 1 such that the array 1 is movable in two axes (azimuth, elevation) may be employed.

### [1-2. Configuration example of module]

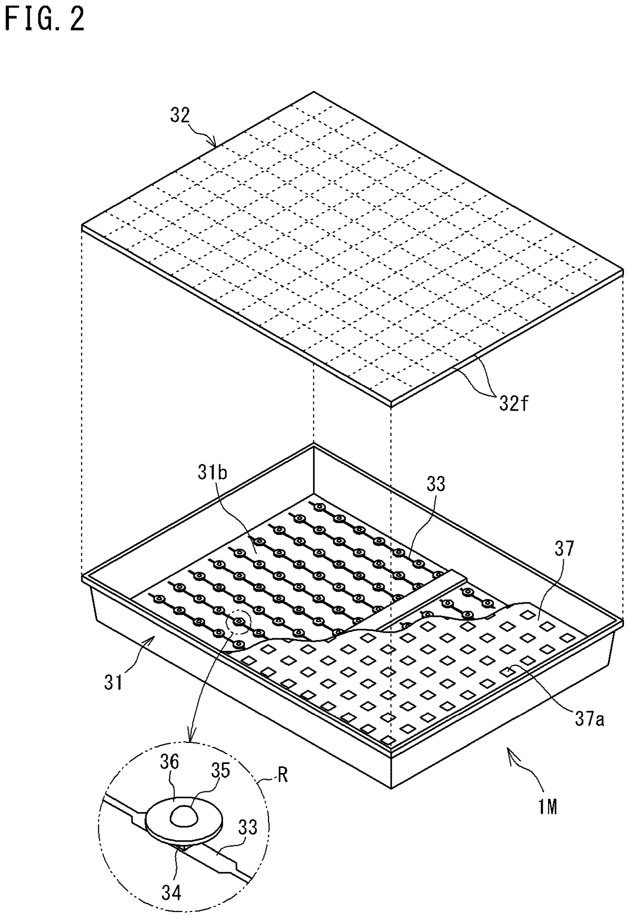

FIG. 2 is a perspective view showing an example of a configuration of the module 1M. In this example, the module 1M is a concentrator photovoltaic module. In the drawing, the module 1M includes: a housing 31 made of, for example, metal and having a rectangular flat-bottomed container shape; and a concentrating portion 32 mounted, like a cover, on the housing 31. The concentrating portion 32 is formed by a plurality of Fresnel lenses 32f arranged in a matrix. For example, each of the indicated square sections (14 squares × 10 squares) is a Fresnel lens 32f serving as a condenser lens, and can cause sunlight to be converged at the focal point.

A flexible printed circuit 33 is disposed on a bottom surface 31b of the housing 31. Cell packages 34 each holding a cell (power generating element) are mounted at predetermined positions on the flexible printed circuit 33. In the drawing, a portion surrounded by "o" depicted by an alternate long and two short dashes line is an enlarged figure of a light receiving portion R. In the light receiving portion R, a secondary lens 35 is provided on the cell package 34, and a protection plate 36 is provided around the secondary lens 35. The secondary lens 35 is, for example, a ball lens. The protection plate 36 is, for example, an annular shaped metal body, and a commercially available washer can be used as the protection plate 36. When converged sunlight deviates from the secondary lens 15, the protection plate 36 prevents the converged light from causing thermal damage to the periphery of the cell. Even when all the converged light enters the secondary lens 35, the protection plate 36 receives scattered light in the housing 31 and reflects the scattered light.

The light receiving portions R are provided so as to respectively correspond to the Fresnel lenses 32f by the same number and at the same interval. A shielding plate 37 is provided between the light receiving portion R and the concentrating portion 32. In the shielding plate 37, openings 37a each having a square shape similar to the outer shape of one Fresnel lens 32f are formed at positions corresponding to the individual Fresnel lenses 32f. Light converged by the Fresnel lens 32f passes through the opening 37a. When the incident direction of sunlight is greatly deviated from the optical axis of the light receiving portion R, the light that will be concentrated to a deviated position hits the shielding plate 37.

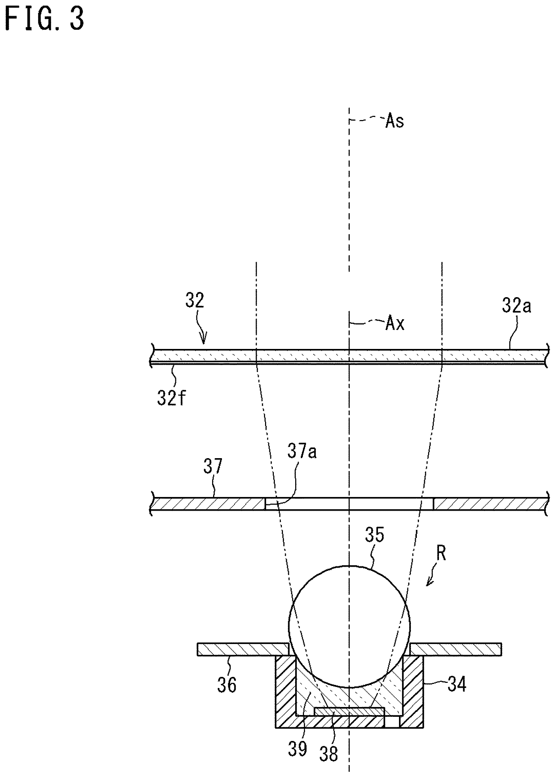

FIG. 3 is an example of a cross-sectional view representing a minimum basic configuration of an optical system. In FIG. 3, the incident direction of sunlight is perpendicular to the Fresnel lens 32f of the concentrating portion 32, and an incident direction As and an optical axis Ax are parallel to each other (that is, the incident direction As and the optical axis Ax coincide with each other). At this time, light converged by the Fresnel lens 32f passes through the opening 37a of the shielding plate 37 and is incident on the secondary lens 35. The secondary lens 35 guides the incident light to a cell 38. The cell 38 is held in the cell package 34. The protection plate 36 is mounted so as to be placed on the upper end of the cell package 34. A light-transmissive resin 39 is enclosed between the secondary lens 35 and the cell 38. As shown in FIG. 3, when the optical axis Ax connecting the Fresnel lens 32f and the cell 38 coincides with the incident direction As of sunlight, all of the light collected by the Fresnel lens 32f is guided to the cell 38. The cell 38 converts most of the received light into electric energy and outputs electric power.

### [1-3. Configuration example of Fresnel lens]

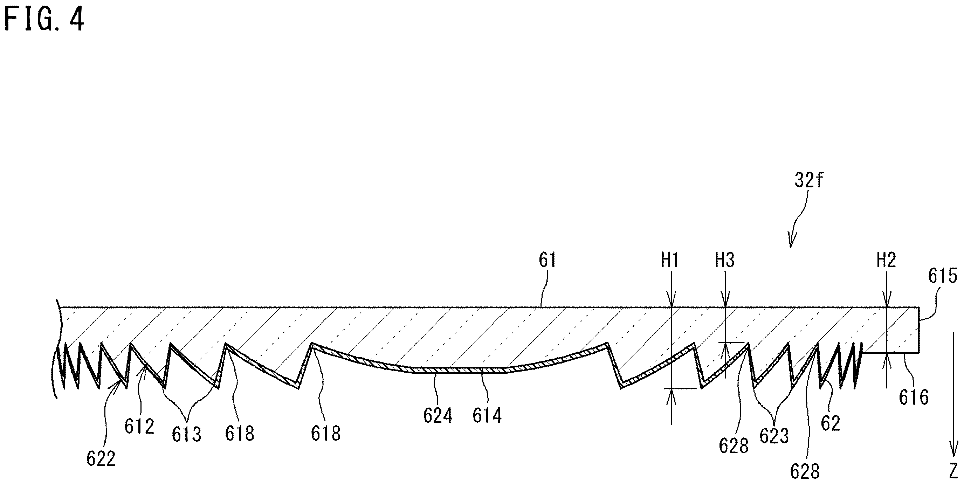

As shown in FIG. 2, in one concentrating portion 32, a plurality of Fresnel lenses 32f are provided in a matrix (10 × 14 lenses). FIG. 4 is a side cross-sectional view showing an example of the configuration of the Fresnel lens according to the present embodiment. In FIG. 4, one of the Fresnel lenses 32f provided in the concentrating portion 32 is shown, and the other Fresnel lenses are not shown. As shown in FIG. 4, the Fresnel lens 32f includes a glass substrate portion 61 and a synthetic resin portion 62.

The glass substrate portion 61 has a first Fresnel shape 612 on one surface thereof. The first Fresnel shape 612 has a plurality of first projection portions 613. The plurality of first projection portions 613 are concentric circular projections having radii different from each other and each have a pointed shape tapered toward an end thereof. Each first projection portion 613 is an example of a first corner portion. The first Fresnel shape 612 further has a plurality of first recess portions 618. The plurality of first recess portions 618 are concentric circular grooves having radii different from each other and each have a shape in which the width becomes narrower toward a bottom thereof. Each first recess portion 618 is an example of the first corner portion. The first projection portions 613 and the first recess portions 618 are alternately provided so as to be concentric with each other. That is, one first recess portion 618 is formed by two first projection portions 613 adjacent to each other. In other words, one first projection portion 613 is formed by two first recess portions 618 adjacent to each other. That is, the first Fresnel shape 612 has a sawtooth shape in a cross-sectional view. The first Fresnel shape 612 is a shape obtained by dividing a convex lens surface into a plurality of concentric circular regions and planarly arranging each region such that the thickness is reduced. That is, each first projection portion 613 has an annular lens surface having the same shape as an annular region cut out from a convex lens surface. In the following description, the projection direction in which the first projection portion 613 projects is referred to as a "Z direction", and one surface in the Z direction of the glass substrate portion 61, that is, the surface on which the first Fresnel shape 612 is provided, is referred to as a "first Fresnel surface".

The synthetic resin portion 62 is overlaid on the first Fresnel surface of the glass substrate portion 61. The synthetic resin portion 62 has a second Fresnel shape 622 on one surface thereof in the Z direction. The second Fresnel shape 622 has a plurality of second projection portions 623. The plurality of second projection portions 623 are concentric circular projections having radii different from each other and each have a pointed shape tapered toward an end thereof. Each second projection portion 623 is an example of a second corner portion. The second Fresnel shape 622 further has a plurality of second recess portions 628. The plurality of second recess portions 628 are concentric circular grooves having radii different from each other and each have a shape in which the width becomes narrower toward a bottom thereof. Each second recess portion 628 is an example of the second corner portion. The second projection portions 623 and the second recess portions 628 are alternately provided so as to be concentric with each other. That is, one second recess portion 628 is formed by two second projection portions 623 adjacent to each other. In other words, one second projection portion 623 is formed by two second recess portions 628 adjacent to each other. That is, the second Fresnel shape 622 has a sawtooth shape in a cross-sectional view. Similar to each first projection portion 613, each second projection portion 623 has an annular lens surface having the same shape as an annular region cut out from a convex lens surface.

The synthetic resin portion 62 is thinly formed so as to cover the surfaces of the first projection portions 613. That is, a synthetic resin is overlaid on the first Fresnel shape 612 so as to match the shapes of the first projection portions 613 and the first recess portions 618, whereby the second projection portions 623 and the second recess portions 628 are formed. As described above, the first projection portions 613 and the second projection portions 623 correspond to each other on a one-to-one basis. The first recess portions 618 and the second recess portions 628 also correspond to each other on a one-to-one basis. A first projection portion 613 and a second projection portion 623 that correspond to each other have the same radius and coaxially overlap each other. A first recess portion 618 and a second recess portion 628 that correspond to each other have the same radius and coaxially overlap each other. That is, the center of the first Fresnel shape 612 and the center of the second Fresnel shape 622 coincide with each other. Owing to such a configuration, the amount of the expensive synthetic resin used can be reduced, so that the material cost of the Fresnel lens is reduced. In addition, since the volume of the synthetic resin portion 62 is reduced, the influence of thermal deformation and deterioration (discoloration) of the synthetic resin portion 62 is suppressed, and variations in power generation amount and a reduction in total power generation amount are suppressed.

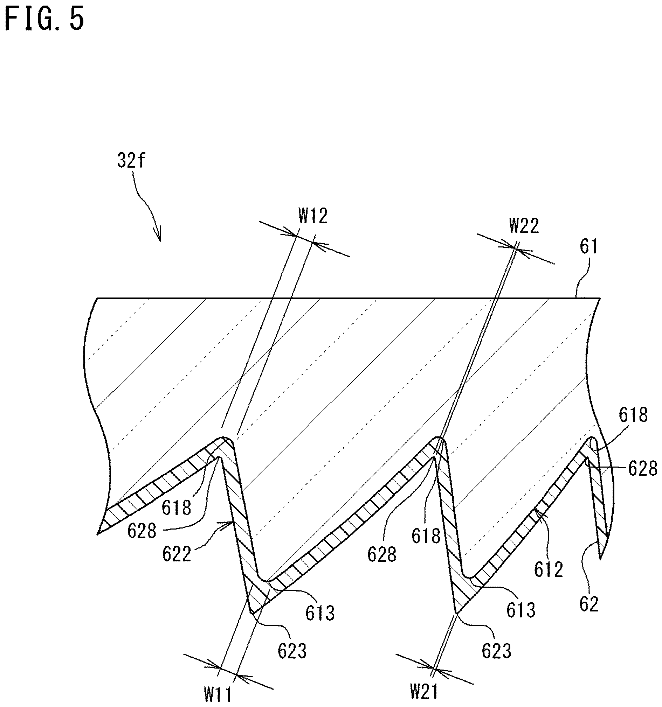

FIG. 5 is a partially enlarged side cross-sectional view of the first Fresnel shape 612 and the second Fresnel shape 622. The glass substrate portion 61 may be formed by pressing or cutting of glass. From the viewpoint of processing cost, the glass substrate portion 61 is preferably formed by pressing of glass. In the pressing, the first Fresnel shape 612 is transferred to a softened glass by a mold. In such pressing of glass, it is difficult to form a sharp shape due to the material characteristics of glass.

The synthetic resin portion 62 is formed from a silicone resin or an acrylic resin. The synthetic resin portion 62 can be molded by injection molding. In such injection molding, the molded glass substrate portion 61 is fitted to a mold for transferring and molding the second Fresnel shape 622, such that the first Fresnel surface faces the mold, the space between the mold and the first Fresnel surface is filled with a heated and melted synthetic resin, and the synthetic resin is cooled, whereby the synthetic resin portion 62 is formed. In injection molding, a sharp shape can be easily formed, as compared with pressing of glass.

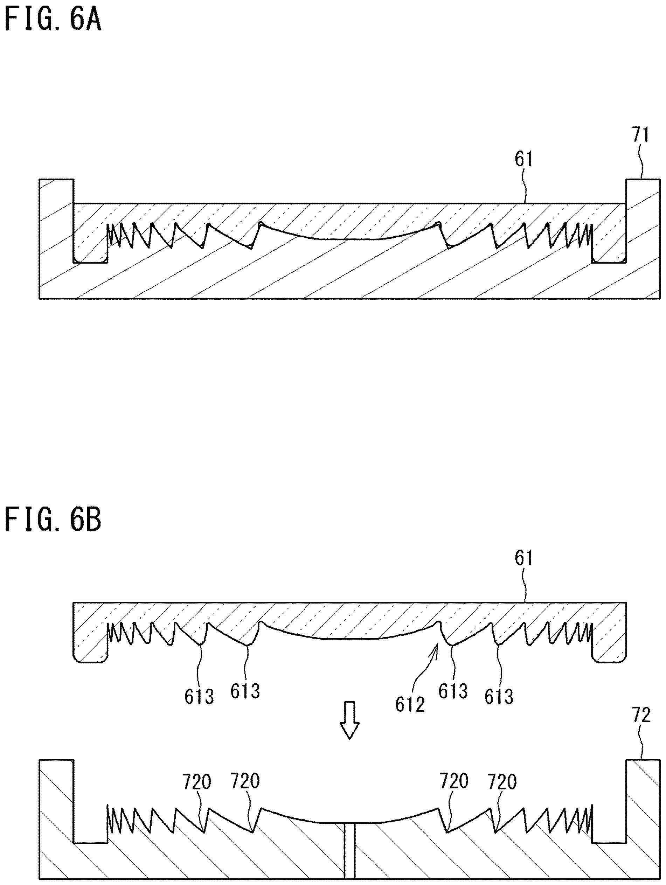

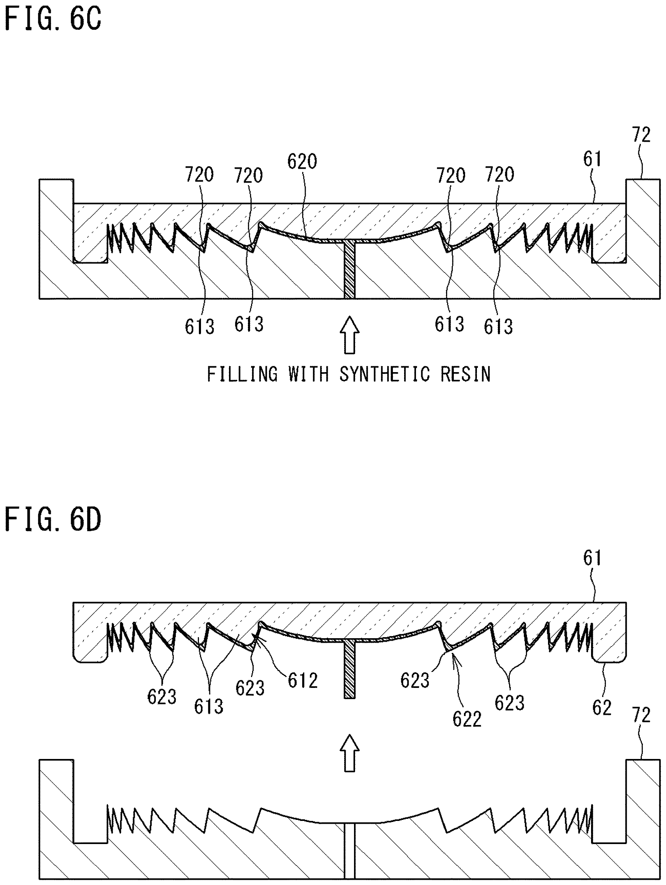

An example of a method for manufacturing the Fresnel lens 32f will be described in detail. FIG. 6A to FIG. 6D are diagrams for describing the example of the method for manufacturing the Fresnel lens 32f according to the present embodiment.

### <Glass substrate production step>

First, in a glass substrate production step, the glass substrate portion 61 is produced. In the example shown in FIG. 6A, the glass substrate portion 61 is produced by pressing. Specifically, a glass plate softened by heat is fitted to a mold 71 for forming the first Fresnel surface. The mold 71 is provided with a pattern surface 710 for forming the first Fresnel shape 612. The pattern surface 710 has a shape opposite to that of the first Fresnel shape 612. That is, the pattern surface 710 has a plurality of concentric circular recess portions corresponding to the first projection portions 613. The glass plate is pressed against the mold 71, and the first Fresnel shape 612 is formed on one surface thereof. Accordingly, the glass substrate portion 61 is produced. The produced glass substrate portion 61 is cooled and then removed from the mold 71.

### <Mold fitting step>

As shown in FIG. 6B, a mold 72 for injection molding is fitted to the glass substrate portion 61. The mold 72 is provided with a pattern surface 721 for forming the second Fresnel shape 622. The pattern surface 721 has a shape opposite to that of the second Fresnel shape 622. That is, the pattern surface 721 has a plurality of concentric circular recess portions 720 corresponding to the second projection portions 623. The glass substrate portion 61 is fitted to the mold 72 such that the plurality of first projection portions 613 of the glass substrate portion 61 are accommodated in the plurality of recess portions 720, respectively.

### <Synthetic resin filling step>

As shown in FIG. 6C, the space between the glass substrate portion 61 and the mold 72 is filled with a heated and melted synthetic resin 620. Due to the material characteristics of glass, the end of each first projection portion 613 of the glass substrate 61 is rounded, and the recess portions between the first projection portions 613 adjacent to each other are also rounded. On the other hand, each recess portion 720 of the mold 72 is sharp, and the projection portions between the recess portions 720 adjacent to each other are also sharp. The space between the mold 72 and the glass substrate portion 61 having such a shape is filled with the synthetic resin 620 in the form of liquid.

### <Synthetic resin portion forming step>

The synthetic resin portion 62 is formed by cooling the synthetic resin 620 with which the space between the glass substrate portion 61 and the mold 72 is filled. As described above, the synthetic resin portion 62 having the sharp second projection portions 623 is formed by injection molding using the mold 72 having the sharp recess portions 720. The synthetic resin 620 is solidified, and then the Fresnel lens 32f (semi-finished product) is removed from the mold 72. The Fresnel lens 32f is completed by removing burrs generated by the injection molding, and performing post-processing such as polishing.

The synthetic resin portion 62 can be formed from a phenyl-based silicone resin. By forming the synthetic resin portion 62 having a small volume from a phenyl-based silicone resin, the influence of thermal deformation and deterioration (yellowing, etc.) of the synthetic resin portion 62 can be reduced, so that the Fresnel lens 32f having excellent optical characteristics can be formed.

In the Fresnel lens 32f according to the present embodiment, the end of each second projection portion 623 is sharper than the end of each first projection portion 613. That is, in FIG. 5, a width W11 of the end of each first projection portion 613 is larger than a width W21 of the end of each second projection portion 623. Specifically, the width W11 is equal to or larger than 0.1 mm and equal to or less than 1 mm, and the width W21 is equal to or larger than 1 µm and equal to or less than 10 µm. Accordingly, the sharpness of each first projection portion 613 can be decreased, so that it is easy to mold the glass substrate portion 61. In addition, the synthetic resin portion 62 has high moldability, and thus the sharp second projection portions 623 can be easily molded. Therefore, the Fresnel lens 32f having good optical characteristics can be easily molded. More preferably, the width W11 is equal to or larger than 0.3 mm and equal to or less than 0.7 mm, and the width W21 is equal to or larger than 1 µm and equal to or less than 10 µm. Accordingly, more excellent optical characteristics can be obtained. However, the above numerical ranges are examples, and the widths W11 and W21 may be dimensions other than the above.

In the Fresnel lens 32f according to the present embodiment, each second recess portion 628 which is a groove formed by second projection portions 623 adjacent to each other is sharper than each first recess portion 618 which is a groove formed by first projection portions 613 adjacent to each other. That is, in FIG. 5, a width W12 of the bottom of each first recess portion 618 is larger than a width W22 of the bottom of each second recess portion 628. Specifically, the width W12 is equal to or larger than 0.1 mm and equal to or less than 1 mm, and the width W22 is equal to or larger than 1 µm and equal to or less than 10 µm. Accordingly, the sharpness of each first recess portion 618 can be decreased, so that it is easy to mold the glass substrate portion 61. In addition, the sharp second recess portions 628 can be easily molded on the synthetic resin portion 62. Therefore, the Fresnel lens 32f having good optical characteristics can be easily molded. More preferably, the width W12 is equal to or larger than 0.3 mm and equal to or less than 0.7 mm, and the width W22 is equal to or larger than 1 µm and equal to or less than 10 µm. Accordingly, more excellent optical characteristics can be obtained. However, the above numerical ranges are examples, and the widths W12 and W22 may be dimensions other than the above.

Reference is made to FIG. 4 again. The first Fresnel shape 612 has a circular first flat surface 614 at a center portion thereof. The second Fresnel shape 622 has a circular second flat surface 624 at a center portion thereof. The first flat surface 614 and the second flat surface 624 overlap each other in the Z direction. The first and second flat surfaces 614 and 624 serve as windows. In work of assembling the module 1M, the cell can be easily viewed or clearly imaged through the first and second flat surfaces 614 and 624, so that it is easy to align the cell and the Fresnel lens 32f with each other.

On one surface of one concentrating portion 32, the above-described Fresnel lenses 32f are provided in a matrix. An outer peripheral portion 615 of the glass substrate portion 61 is provided around the Fresnel lenses 32f provided on one concentrating portion 32. That is, the glass substrate portion 61 includes the outer peripheral portion 615 around the first Fresnel shapes 612 provided in a matrix. In one concentrating portion 32, the outermost Fresnel lenses 32f are adjacent to the outer peripheral portion 615. In FIG. 4, the Fresnel lens 32f at the end of the concentrating portion 32 is shown.

The outer peripheral portion 615 is a rectangular annular portion having a constant thickness (length in the Z direction) and serves as a connection portion connected to the housing 31 of the module 1M. The synthetic resin portion 62 is not overlaid on the outer peripheral portion 615, and the surface of the outer peripheral portion 615 is a glass surface. It should be noted that the synthetic resin portion 62 may be overlaid on the surface of the outer peripheral portion 615.

A thickness H2 of the outer peripheral portion 615 is smaller than the maximum thickness (thickness at the end of each second projection portion 623) H1 in the second Fresnel shape 622 of the Fresnel lens 32f. That is, an end surface, of the outer peripheral portion 615, facing in the projection direction of the second projection portion 623 (Z direction), that is, a connection surface 616 connected to the housing 31, is lower in the Z direction than the end position of the second projection portion 623.

The thickness H2 of the outer peripheral portion 615 is larger than the minimum thickness (thickness at the bottom of a first groove) H3 in the first Fresnel shape 612 of the glass substrate portion 61. That is, the end surface, of the outer peripheral portion 615, facing in the projection direction of the second projection portion (Z direction), that is, the connection surface 616 connected to the housing 31, is higher in the Z direction than the first groove.

### [1-4. Configuration of concentrator photovoltaic system]

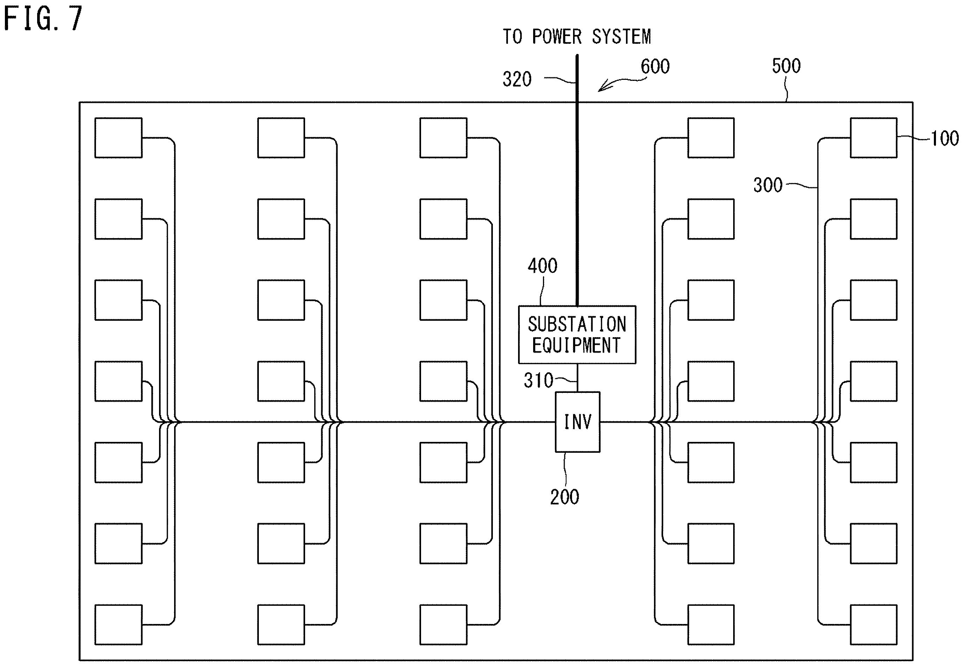

A concentrator photovoltaic system including a plurality of concentrator photovoltaic apparatuses 100 configured as described above can be configured. FIG. 7 is a diagram showing an example of a configuration of a concentrator photovoltaic system according to the present embodiment. FIG. 7 shows a state where the concentrator photovoltaic apparatuses 100 are arranged, as viewed from above.

The plurality of concentrator photovoltaic apparatuses 100 are installed in an installation area 500 provided in a site of an organization that operates a concentrator photovoltaic system 600. In the example shown in FIG. 7, 35 concentrator photovoltaic apparatuses 100 are installed in a matrix of 5 columns and 7 rows. Each concentrator photovoltaic apparatus 100 generates power while tracking the sun such that a light receiving surface of the array 1 faces the sun. For this reason, concentrator photovoltaic apparatuses 100 adjacent to each other are spaced apart from each other at a predetermined interval such that the respective concentrator photovoltaic apparatuses 100 do not come into contact with each other during sun tracking.

In the installation area 500, an inverter apparatus 200 that converts DC power into AC power is disposed. The concentrator photovoltaic apparatuses 100 and the inverter apparatus 200 are connected by DC cables 300. The inverter apparatus 200 causes the connected concentrator photovoltaic apparatuses 100 to perform efficient power generation by MPPT (Maximum Power Point Tracking) control.

The number of inverter apparatuses 200 provided in the installation area 500 may be one or may be plural. In addition, the number of inverter apparatuses 200 may be equal to the number of concentrator photovoltaic apparatuses 100, or may be smaller than the number of photovoltaic apparatuses. That is, DC power from the plurality of concentrator photovoltaic apparatus 100 may be converted into AC power by one inverter apparatus 200 or by a plurality of inverter apparatuses 200.

One end of an AC cable 310 is connected to the output side of the inverter apparatus 200. In the installation area 500, substation equipment 400 is installed. The other end of the AC cable 310 is connected to the input side of the substation equipment 400.

The AC power outputted from the inverter apparatus 200 is inputted to the substation equipment 400 by the AC cable 310. The substation equipment 400 transforms the inputted AC voltage. A power transmission cable 320 extends from the output side of the substation equipment 400, and the output AC power is sent to a power system by the power transmission cable 320.

### [2. Modifications]

Hereinafter, modifications of the embodiment will be described.

### [2-1. First modification]

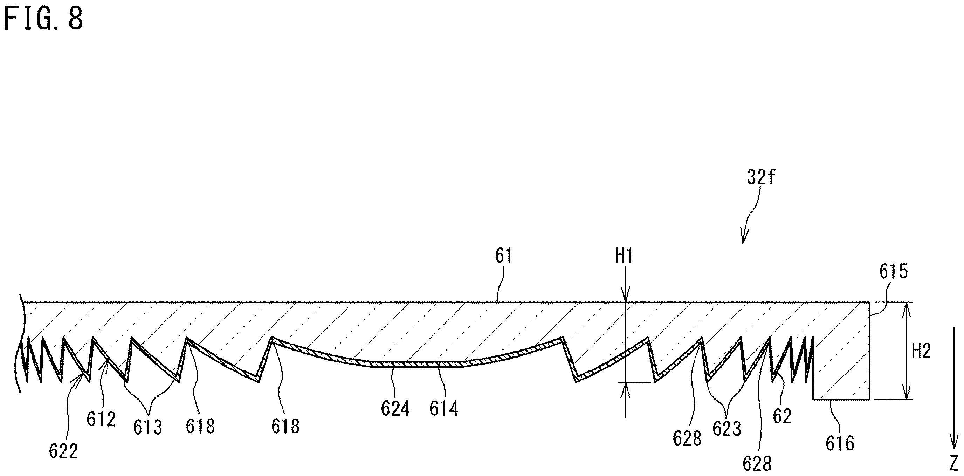

FIG. 8 is a side cross-sectional view showing a configuration of a Fresnel lens according to a first modification of the embodiment. In the Fresnel lens 32f according to the first modification, the thickness H2 of the outer peripheral portion 615 is equal to or larger than the maximum thickness (thickness at the end of each second projection portion 623) H1 in the second Fresnel shape 622 of the Fresnel lens 32f. That is, the connection surface 616 of the outer peripheral portion 615 is higher in the Z direction than the end position of the second projection portion 623.

Accordingly, since the outer peripheral portion 615 protrudes more in the Z direction than the second projection portion 623, another object is inhibited from coming into contact with a portion of the second Fresnel shape 622 during transportation or the like, so that damage and adhesion of dirt to the Fresnel lens 32f can be inhibited.

### [2-2. Second modification]

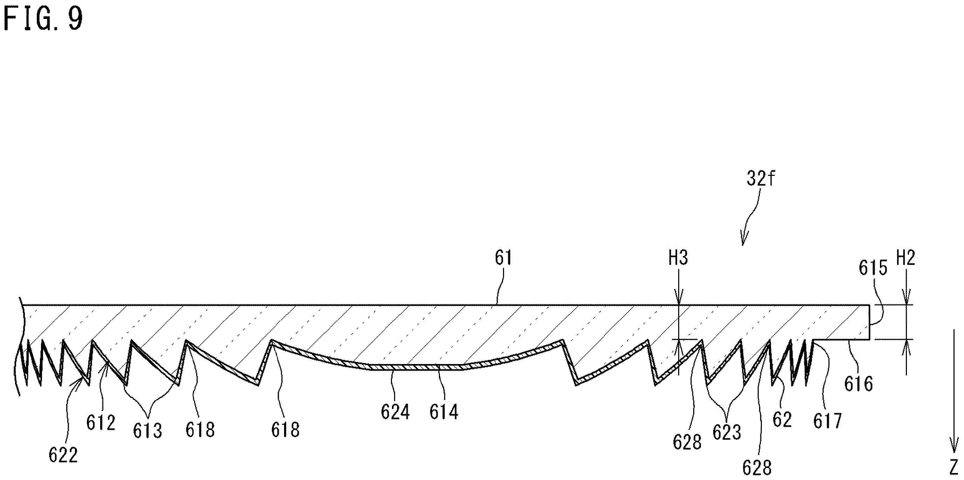

FIG. 9 is a side cross-sectional view showing a configuration of a Fresnel lens according to a second modification of the embodiment. In the Fresnel lens 32f according to the second modification, the thickness H2 of the outer peripheral portion 615 is equal to or less than the minimum thickness (thickness at the bottom of the first groove) H3 in the first Fresnel shape 612 of the glass substrate portion 61. That is, the connection surface 616 of the outer peripheral portion 615 is lower in the Z direction than the first groove.

Accordingly, the volume of the glass substrate portion 61 is reduced, and the amount of glass used is reduced. Thus, the cost and the weight can be reduced. In addition, when mounting the Fresnel lens 32f to the housing 31 of the module 1M, it is possible to align the Fresnel lens 32f and the housing 31 with each other by fitting the housing 31 to a step portion 617 formed at the boundary between the outer peripheral portion 615 and a portion of the second Fresnel shape 622.

### [2-3. Third modification]

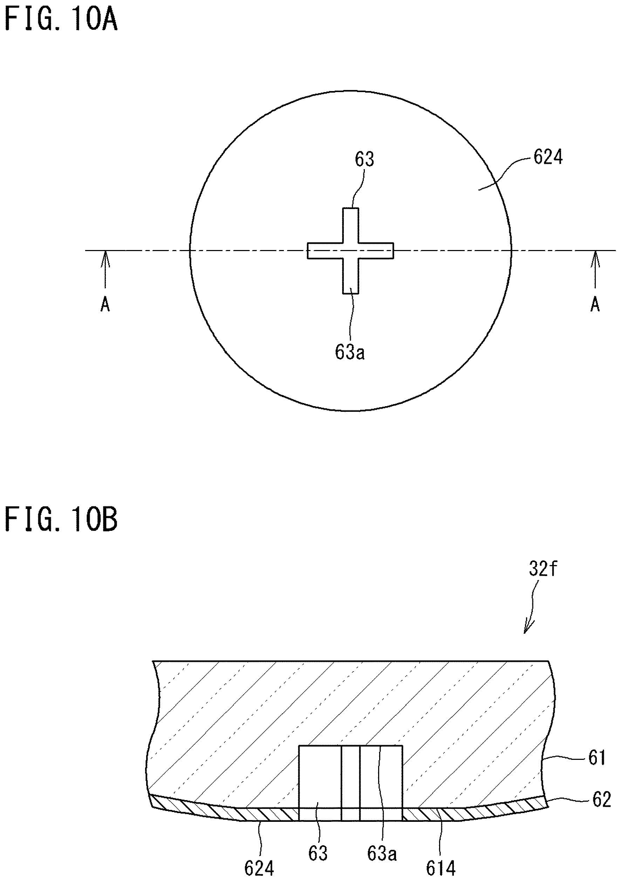

FIG. 10A is an enlarged front view of a center portion of a Fresnel lens according to a third modification of the embodiment, and FIG. 10B is a cross-sectional view taken along a line A-A shown in FIG. 10A. A mark portion 63 that is a recess portion having a cross shape in a front view is provided on the center portion of the Fresnel lens 32f according to the third modification, that is, on portions of the first and second flat surfaces 614 and 624. The mark portion 63 is provided with a predetermined depth D in the Z direction. The mark portion 63 has an end surface opposite to the first Fresnel surface of the glass substrate portion 61, that is, a bottom surface 63a parallel to a plane perpendicular to the Z direction. The bottom surface 63a is a flat surface. Therefore, when the light receiving surface of the array 1 faces the sun directly from the front through sun tracking, the bottom surface 63a becomes perpendicular to the incident direction of sunlight, and optical loss is suppressed.

The mark portion 63 can be used for aligning the cell and the Fresnel lens 32f with each other in the work of assembling the module 1M. In the case where a mark having a cross shape or the like is provided to a cell, the cell and the Fresnel lens 32f can be aligned with each other by image processing or visual inspection such that the mark and the center of the mark portion 63 coincide with each other.

### [2-4. Fourth modification]

In the above embodiment, the thin layer-shaped synthetic resin portion 62 overlaid on the first Fresnel surface has been described, but the synthetic resin portion is not limited thereto. A synthetic resin portion according to this modification is provided in an annular shape along the first projection portion 613 or the first recess portion 618.

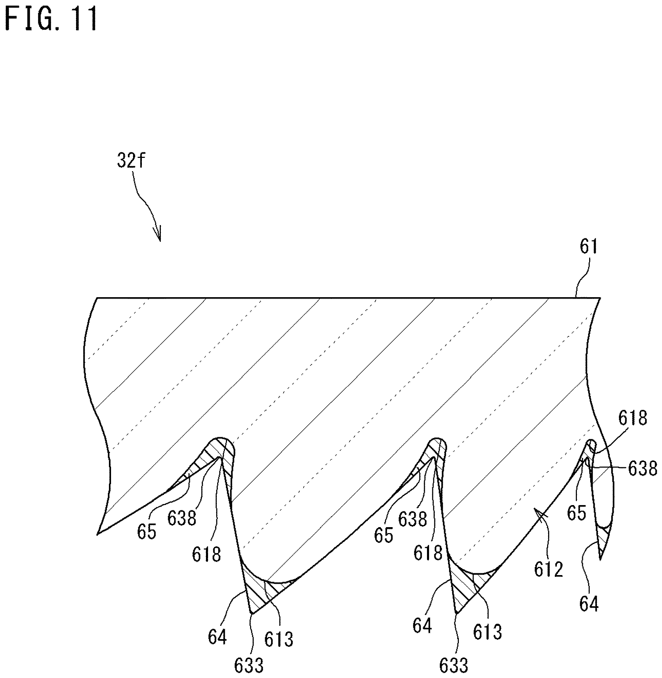

FIG. 11 is a partially enlarged side cross-sectional view of a Fresnel lens according to a fourth modification of the embodiment. The Fresnel lens 32f according to this modification includes synthetic resin portions 64 and 65. The synthetic resin portion 64 is provided at the end portion of each first projection portion 613. That is, in the Fresnel lens 32f according to this modification, a plurality of synthetic resin portions 64 are provided so as to be concentric with each other. Each of the synthetic resin portions 64 has a second projection portion 633. The second projection portion 633 is an example of the second corner portion. The second projection portion 633 has a pointed shape tapered toward an end thereof. The end of the second projection portion 633 is sharper than the end of the first projection portion 613.

The synthetic resin portion 65 is provided at the bottom portion of each first recess portion 618. That is, in the Fresnel lens 32f according to this modification, a plurality of synthetic resin portions 65 are provided so as to be concentric with each other. Each of the synthetic resin portions 65 has a second recess portion 638. The second recess portion 638 is an example of the second corner portion. The second recess portion 638 has a shape in which the width decreases toward a bottom thereof. The bottom of the second recess portion 638 is sharper than the bottom of the first recess portion 618.

### [2-5. Fifth modification]

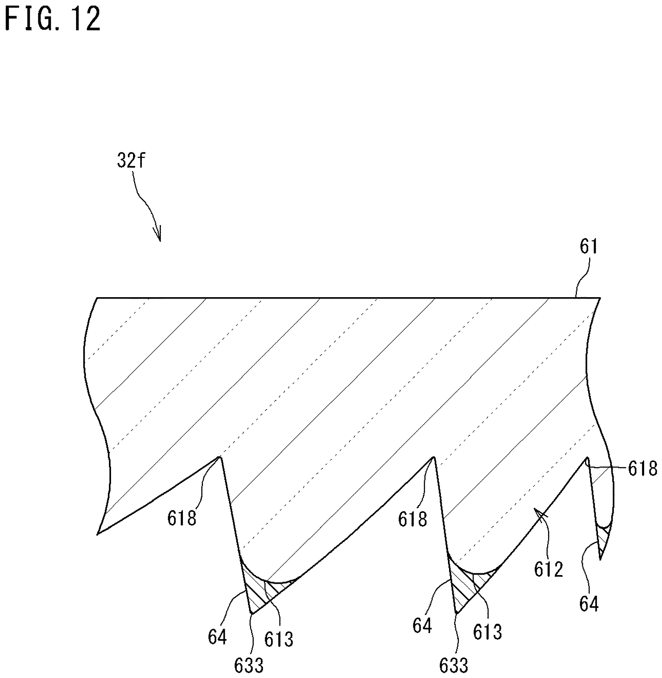

The Fresnel lens 32f may include only either of the synthetic resin portions 64 and 65. FIG. 12 is a partially enlarged side cross-sectional view of a Fresnel lens according to a fifth modification of the embodiment. In the Fresnel lens 32f according to this modification, the glass substrate portion 61 has first recess portions 618 each having a groove shape and a sharp bottom. Therefore, it is not necessary to provide second recess portions made of a synthetic resin. At the end of each first projection portion 613, a synthetic resin portion 64 having a second projection portion 633 is provided.

### [2-6. Sixth modification]

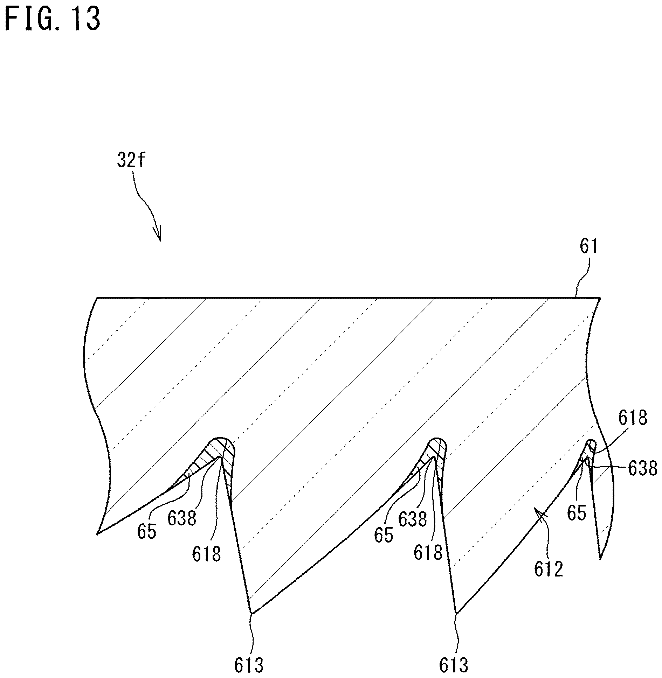

FIG. 13 is a partially enlarged side cross-sectional view of a Fresnel lens according to a sixth modification of the embodiment. In the Fresnel lens 32f according to this modification, the glass substrate portion 61 has first projection portions 613 each of which is a projection having a sharp end. Therefore, it is not necessary to provide second projection portions made of a synthetic resin. At the bottom of each first recess portion 618, a synthetic resin portion 65 having a second recess portion 638 is provided.

### [2-7. Another modification]

In the above embodiment, the synthetic resin portion 62 is overlaid on the first flat surface 614 to provide the second flat surface 624, but the configuration is not limited thereto. The first flat surface 614 does not have to be covered with the synthetic resin portion 62 and may be exposed.

### [3. Supplementary note]

The above embodiment is merely illustrative in all aspects and should not be recognized as being restrictive. The scope of the present disclosure is defined by the scope of the claims, and is intended to include meaning equivalent to the scope of the claims and all modifications within the scope.

### REFERENCE SIGNS LIST

- 100: concentrator photovoltaic apparatus
- 1: array
- 2: support device
- 1M: concentrator photovoltaic module
- 21: post
- 22: base
- 23: axial drive part
- 24: horizontal shaft
- 31: housing
- 32: concentrating portion
- 32f: Fresnel lens
- 33: flexible printed circuit
- 34: cell package
- 35: secondary lens
- 36: protection plate
- 37: shielding plate
- 37a: opening
- 38: cell
- 39: resin
- 200: inverter apparatus
- 300: DC cable
- 310: AC cable
- 320: power transmission cable
- 400: substation equipment
- 500: installation area
- 600: concentrator photovoltaic system
- 61: glass substrate portion
- 612: first Fresnel shape
- 613: first projection portion
- 614: first flat surface
- 615: outer peripheral portion
- 616: connection surface
- 617: step portion
- 618: first recess portion
- 62, 64, 65: synthetic resin portion
- 622: second Fresnel shape
- 623, 633: second projection portion
- 624: second flat surface
- 628, 638: second recess portion
- 63: mark portion
- 63a: bottom surface

## Claims

1. A Fresnel lens for a concentrator photovoltaic apparatus, comprising:
a glass substrate portion having a circular first corner portion; and
a synthetic resin portion overlaid on one surface of the glass substrate portion and having a circular second corner portion having a radius equal to that of the first corner portion and coaxially overlapping the first corner portion.

2. The Fresnel lens for a concentrator photovoltaic apparatus according to claim 1, wherein
the first corner portion is a first projection portion having a projected corner shape,
the second corner portion is a second projection portion having a projected corner shape, and
an end of the second projection portion is sharper than an end of the first projection portion.

3. The Fresnel lens for a concentrator photovoltaic apparatus according to claim 2, wherein a width of the end of the first projection portion is equal to or larger than 0.1 mm and equal to or less than 1 mm.

4. The Fresnel lens for a concentrator photovoltaic apparatus according to claim 1, wherein
the first corner portion is a first recess portion having a recessed corner shape,
the second corner portion is a second recess portion having a recessed corner shape, and
a bottom of the second recess portion is sharper than a bottom of the first recess portion.

5. The Fresnel lens for a concentrator photovoltaic apparatus according to claim 4, wherein a width of the bottom of the first recess portion is equal to or larger than 0.1 mm and equal to or less than 1 mm.

6. The Fresnel lens for a concentrator photovoltaic apparatus according to any one of claims 1 to 5, wherein
the glass substrate portion has a first flat surface at a center portion thereof, and
the synthetic resin portion has, at a center portion thereof, a second flat surface overlapping the first flat surface.

7. The Fresnel lens for a concentrator photovoltaic apparatus according to any one of claims 1 to 6, wherein
the glass substrate portion has an outer peripheral portion having a constant thickness, and
the outer peripheral portion projects further than a position of the end of the second projection portion in a projection direction in which the second projection portion projects.

8. The Fresnel lens for a concentrator photovoltaic apparatus according to any one of claims 1 to 6, wherein
the glass substrate portion has an outer peripheral portion having a constant thickness,
the outer peripheral portion has an end surface facing in a projection direction in which the second projection portion projects, and
a height in the projection direction of the end surface is equal to or smaller than a height in the projection direction of a groove formed between the two first projection portions adjacent to each other.

9. The Fresnel lens for a concentrator photovoltaic apparatus according to any one of claims 1 to 8, wherein the synthetic resin portion is formed from a phenyl-based silicone resin.

10. A Fresnel lens for a concentrator photovoltaic apparatus, comprising:
a glass substrate portion having, on one surface thereof, a first Fresnel shape having a plurality of concentric circular first projection portions; and
a synthetic resin portion overlaid on the one surface of the glass substrate portion and having, on one surface thereof, a second Fresnel shape having a plurality of concentric circular second projection portions having radii equal to those of the first projection portions, respectively, and coaxially overlapping the first projection portions, respectively.

11. A concentrator photovoltaic system comprising:
a plurality of concentrator photovoltaic apparatuses; and
an inverter apparatus configured to convert DC power outputted from the plurality of concentrator photovoltaic apparatuses, into AC power, wherein
each of the concentrator photovoltaic apparatuses includes a concentrator photovoltaic panel including the Fresnel lens for a concentrator photovoltaic apparatus according to any one of claims 1 to 10.

12. A method for manufacturing a Fresnel lens for a concentrator photovoltaic apparatus, the method comprising the steps of:
producing a glass substrate portion including, on one surface thereof, a Fresnel shape having a plurality of concentric circular first projection portions, by pressing or cutting;
fitting the glass substrate portion to a mold having a plurality of concentric circular recess portions, such that the plurality of first projection portions are accommodated in the plurality of recess portions, respectively;
filling a space between the glass substrate portion and the mold with a heated and melted synthetic resin; and
forming a synthetic resin portion overlaid on the one surface of the glass substrate and having a plurality of concentric circular second projection portions having radii equal to those of the first projection portions, respectively, and coaxially overlapping the first projection portions, respectively, by cooling the synthetic resin.
